(19)

Europäisches
Patentamt
European
Patent Office
Office européen
des brevets

(11) **EP 4 749 366 A1**

(12) **EUROPEAN PATENT APPLICATION**

(43) Date of publication:
**27.05.2026 Bulletin 2026/22**

(21) Application number: **24215456.5**

(22) Date of filing: **26.11.2024**

(51) International Patent Classification (IPC):
***G03F 7/20*** *(2006.01)*     ***G01N 21/956*** *(2006.01)*

(52) Cooperative Patent Classification (CPC):
**G03F 7/70633; G01N 21/956; G03F 7/706849;
G03F 7/706851**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ASML Netherlands B.V.
5500 AH Veldhoven (NL)**

(72) Inventors:
• **COENE, Willem Marie Julia Marcel
  5500 AH Veldhoven (NL)**
• **VAN PUTTEN, Eibert Gerjan
  5500 AH Veldhoven (NL)**
• **TINNEMANS, Patricius Aloysius Jacobus
  5500 AH Veldhoven (NL)**
• **WARNAAR, Patrick
  5500 AH Veldhoven (NL)**

(74) Representative: **ASML Netherlands B.V.
Corporate Intellectual Property
P.O. Box 324
5500 AH Veldhoven (NL)**

(54) **ASSEMBLIES AND METHODS FOR MULTI-CHANNEL METROLOGY**

(57)     Assembly for determining a characteristic of a structure on a substrate, comprising a radiation illumination dipole having first and second sources that are angularly offset to a transverse direction in an illumination pupil plane. The first and second sources irradiate a structure having a periodically repeating pattern along a transverse. A multi-part wedge is located in an exit pupil of the assembly, configured to receive from the structure: a lower radiation order and a higher radiation order of diffracted radiation of the first source on a first part of the multi-part wedge, and a lower radiation order and a higher radiation order of diffracted radiation of the second source on a second part of the multi-part wedge. A detector receives a first and second spatially separated images formed from first and second source radiation incident on the first and second parts of the wedge, respectively.

Fig. 6

**Description**

<u>FIELD</u>

The present invention relates to assemblies and methods for detecting a characteristic of a structure on a substrate. Specifically, it may relate to two-channel assemblies and methods for measuring overlay in a lithographically patterned structure on a semiconductor substrate.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_l$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, right control loops for controlling a stability of the lithographic apparatus may be used to improve reproduction of the pattern at low $k_1$.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modem product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

In order to obtain the resolution the metrology or inspection tool is capable of, image data should be in focus, aligned, and obtained in a stable environment. Factors that can impact the quality of the image acquisition (e.g. focus), such as vibrations, movement, changes in temperature, pressure, etc. may be controlled so as to reduce or minimize their impact on data collection.

SUMMARY

According to an aspect of the current disclosure there is provided an assembly for determining a characteristic of a structure on a substrate. The assembly comprises a radiation illumination dipole comprising a first source and a second source, wherein the first source and the second source are angularly offset to a transverse direction in an illumination pupil plane. The first source and the second source are configured to irradiate the structure, the structure having a periodically repeating pattern along the transverse direction. The assembly comprises an exit pupil comprising a multi-part wedge configured to receive from the structure: a lower radiation order and a higher radiation order of diffracted radiation of the first source on one or more first parts of the multi-part wedge, and a lower radiation order and a higher radiation order of diffracted radiation of the second source on one or more second parts of the multi-part wedge. The assembly further comprises a detector configured to receive a first image on the detector formed from the first source radiation incident on the one or more first parts of the wedge and a second image on the detector formed from the second source radiation incident on the one or more second parts of the wedge. The first image and the second image are spatially separated on the detector.

Optionally, the first image and the second image may be formed simultaneously.

Optionally, the characteristic to be measured may be overlay.

Optionally, the structure may comprise a metrology target.

Optionally, the multi-part wedge may be a two-part wedge.

Optionally, the lower radiation order of the first source may be a specular reflected radiation order and the higher radiation order of the first source may be one of a positive or negative first order diffracted radiation. The lower radiation order of the second source may be a specular reflected radiation order and the higher radiation order of the second source may be the other one of a positive or negative first order diffracted radiation. the first part of the two-part wedge and the second part of the two-part wedge are divided along a line that is parallel to the transverse direction of the repeating pattern of the structure.

Optionally, the first part of the two-part wedge may change direction of incident radiation in one or more first directions, and the second part of the two-part wedge may change direction of the incident radiation in one or more second directions, wherein the first directions and the second directions are different.

Optionally, the multi-part wedge may be a six-part wedge. The structure may comprise a further periodically repeating pattern along a longitudinal direction that is perpendicular to the transverse direction.

Optionally, the exit pupil may be configured to receive, from the structure a specular reflected radiation and one of a positive or negative first order diffracted radiation from the periodically repeating pattern along the transverse direction and a specular reflected radiation and one of a positive or negative first order diffracted radiation from the periodically repeating pattern along the longitudinal direction of the first source on two or more first parts of the six-part wedge. The exit pupil may further be configured to receive, from the structure a specular reflected radiation and the other one of a positive or negative first order diffracted radiation from the periodically repeating pattern along the transverse direction and a specular reflected radiation and the other one of a positive or negative first order diffracted radiation from the periodically repeating pattern along the longitudinal direction of the first source on two or more second parts of the six-part wedge.

Optionally, the first parts of the wedge may comprise two or more separate portions of the wedge configured to send radiation in a first direction towards the first part of the detector. The second parts of the wedge may comprise a second group of two or more separate portions of the wedge configured to send radiation in a second direction towards the second part of the detector.

Optionally, the two or more separate portions of the first group may be separated by the two or more separate portions of the second group.

Optionally, the first parts may comprise three parts, including a part having a quarter size, and two diagonally opposing parts having an eighth-size, the two diagonally opposing parts located in quarters next to the quarter-size wedge and not touching the quarter-size part of the first parts. The second parts may comprise three parts, including a part having a quarter size, and two diagonally opposing parts having an eighth-size, the two diagonally opposing parts located in quarters next to the quarter-size part. The quarter size part of the first group may be diagonally opposed to the quarter size wedge of the second group.

Optionally, the multi-part wedge may be a four-part wedge.

Optionally, the lower radiation order and the higher radiation order from the first source may be incident on a same quarter on the first part of the wedge. The lower radiation order and the higher radiation order from the second source may be incident on a same quarter on the second part of the wedge.

Optionally, the assembly may be configured to measure a structure that comprises at least two non-overlapping diffraction gratings.

Optionally, the two non-overlapping diffraction gratings may have a same size, pitch, and direction.

Optionally, the non-overlapping diffraction gratings may be line gratings having lines along a longitudinal direction that is perpendicular to the transverse direction.

Optionally, the non-overlapping gratings may be located in different layers of the substrate.

Optionally, the multi-part wedge may cover the exit pupil of the assembly.

Optionally the assembly may be configured to measure a structure that comprises at least two pairs of non-overlapping diffraction gratings.

Optionally, the gratings in a pair of non-overlapping diffraction gratings may have the same size and pitch.

Optionally, a first pair of diffraction gratings may have lines in a longitudinal direction perpendicular to the transverse direction, and a second pair of diffraction gratings may have lines in the transverse direction.

Optionally, the non-overlapping gratings in a pair may be located in different layers of the substrate.

Optionally, the structure may comprise a first pair of non-overlapping gratings positions on a first diagonal of a square, and a second pair of non-overlapping grating positioned on a second diagonal of the square.

Optionally, the first source and the second source may be angularly offset to both the transverse direction and a longitudinal direction perpendicular to the transverse direction in the illumination pupil plane.

Optionally, the first source and the second source may be positioned point-symmetrically with respect to a center of an illumination pupil in the illumination pupil plane.

Optionally, the angular offset may be less than 45 degrees relative to the transverse direction.

Optionally, the angular offset may be in a range of 5 degrees to 20 degrees relative to the transverse direction.

Optionally, the first source and the second source may be formed by apertures in a blocking screen located in the illumination pupil plane in front of a radiation source.

Optionally, the radiation source may be a spatially incoherent radiation source.

Optionally, the radiation source may be a tunable source with wavelengths in a range of 200 nm - 2000 nm.

Optionally, the radiation source may be configured to output small bandwidth radiation.

Optionally, the first source and the second source may comprise incoherent radiation.

Optionally, the first source and the second source may be mutually incoherent.

Optionally, the assembly may comprise a 4F optics setup.

Optionally, the assembly may further comprise a substrate support for holding the substrate comprising the structure, wherein the substrate support is located in an input plane of the 4F optics optics, the multi-part wedge is located in a Fourier plane of the 4F optics setup, and the detector is located in an output plane of the 4F optics setup.

According to another aspect of the current disclosure, there is provided a method for determining a characteristic of a structure on a substrate. The method comprises receiving radiation from a radiation illumination dipole comprising a first source and a second source, wherein the first source and the second source are angularly offset to a transverse direction in an illumination pupil plane. The method comprises irradiating, by the first source and the second source, the structure, the structure having a periodically repeating pattern along the transverse direction. The method comprises receiving, at an exit pupil comprising a multi-part wedge: a lower radiation order and a higher radiation order of diffracted radiation of the first source on a first part of the multi-part wedge; and a lower radiation order and a higher radiation order of diffracted radiation of the second source on a second part of the multi-part wedge. The method comprises detecting, by a detector, a first image on the detector formed from the first source radiation incident on the first part of the wedge and a second image on the detector formed from the second source radiation incident on the second part of the wedge, wherein the first image and the second image are spatially separated on the detector.

Optionally, the first image may comprise a first diffraction pattern formed by the lower radiation order and the higher radiation order of the first source, and the second image comprises a second diffraction pattern formed from interaction of the lower radiation order and the higher radiation order of the second source.

Optionally, the method may further comprise comparing the first image and the second image to determine a relative phase difference between the diffraction patterns.

Optionally, the method may further comprise determining overlay of the structure on the substrate based on analysis of the first image and the second image.

According to another aspect of the current disclosure, there is provided an apparatus comprising an assembly as described above.

According to another aspect of the current disclosure, there is provided a system comprising an assembly as described above.

According to another aspect of the current disclosure, there is provided a system comprising an assembly as described above, and further comprising a structure, the structure comprising at least two non-overlapping diffraction gratings.

Optionally, the non-overlapping diffraction gratings may be line gratings having lines along a longitudinal direction perpendicular to the transverse direction.

Optionally, the non-overlapping gratings may be located in different layers of the substrate.

According to another aspect of the current disclosure, there is provided a metrology apparatus comprising an assembly as described above.

According to another aspect of the current disclosure, there is provided an inspection apparatus comprising an assembly as described above.

According to another aspect of the current disclosure, there is provided a lithographic apparatus comprising an assembly as described above.

According to another aspect of the current disclosure, there is provided a litho cell comprising an apparatus as described above.

According to another aspect of the current disclosure, there is provided an exposure apparatus for a semiconductor manufacturing process comprises an assembly as described above.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;

- Figure 2 depicts a schematic overview of a lithographic cell;

- Figure 3 depicts a schematic representation of holistic lithography, representing a cooperation between three key technologies to optimize semiconductor manufacturing;

- Figure 4 schematically illustrates a scatterometry apparatus;

- Figure 5 schematically illustrates a transmissive scatterometry apparatus;

- Figure 6 depicts a schematic representation of an assembly for measuring a characteristic of a structure on a substrate;

- Figure 7 depicts a schematic representation of a structure comprising a target with non-overlapping structures;

- Figure 8 depicts a schematic representation of diffraction orders being incident on a two-part wedge in an exit pupil of the assembly;

- Figure 9 depicts a schematic representation of a structure comprising a target with two pairs of non-overlapping structures;

- Figure 10 depicts a schematic representation of diffraction orders being incident on a six-part wedge in an exit pupil of the assembly;

- Figure 11 depicts a schematic representation of diffraction order being incident on a four-part wedge in an exit pupil of the assembly;

- Figure 12 depicts a schematic representation of phase signals associated with a target with non-overlapping structures illuminated by a illumination dipole;

- Figure 13 depicts a schematic representation of various contributions to the fringe patterns;

- Figure 14 depicts a flow charts of steps in a method for measuring a characteristic of a structure on a substrate;

- Figure 15 depicts a schematic representation of an example computer system in which embodiments can be implemented.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultraviolet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

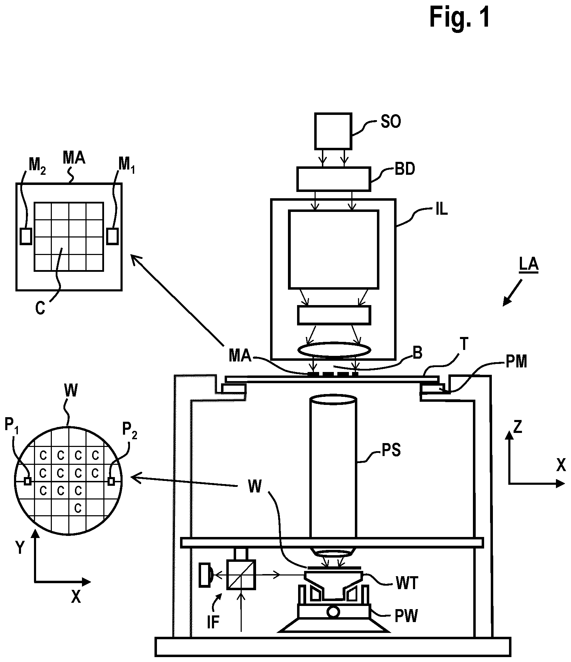

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

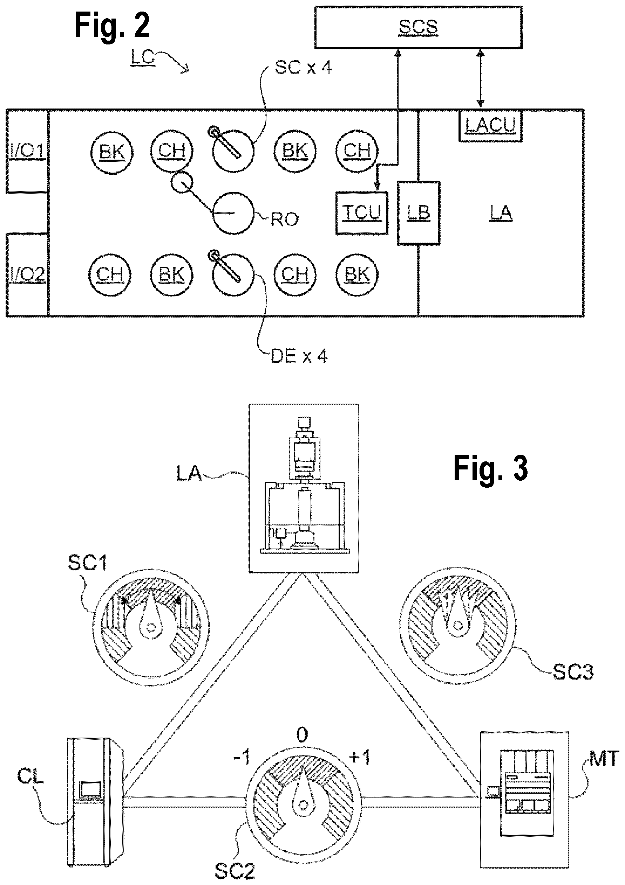

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from from multiple gratings using light from soft x-ray and visible to near-IR wave range.

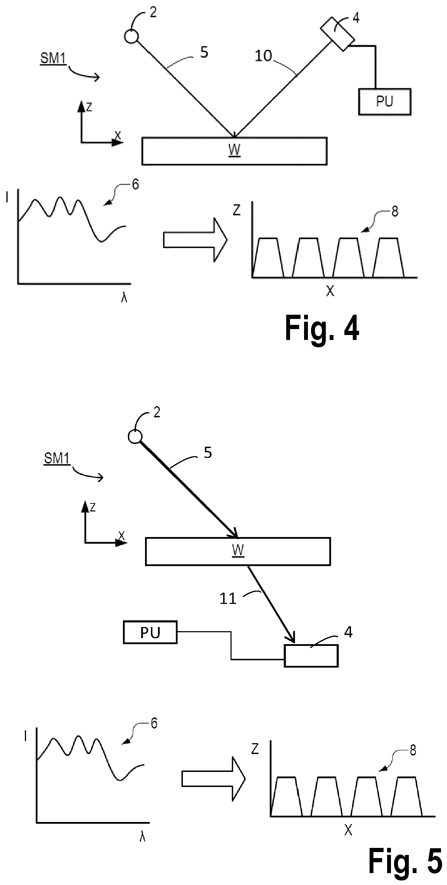

A metrology apparatus, such as a scatterometer, is depicted in figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

Structures may be lithographically patterned onto a substrate using lithographic apparatus as described above. These patterned structures may in turn be measured with different types of metrology and/or inspection apparatus described above. Structures patterned on a substrate (e.g. a wafer) may be complex, and may require multiple different layers of material to be deposited and patterned. In order to create a completed and functional patterned structure on a substrate, the different deposited layers and patterns created in them need to be accurately "lined up". Many different properties need to be tuned in individual layers, as well as between different layers to create a functional overall structure, which may be of a 3D character. These properties, or characteristics of the structures on the substrate include for example focus, dose, alignment, levelling, and/or overlay. Different measurement setups may be provided to measure and inspect these different properties. Measuring these properties may for example be used to monitor performance of the lithography apparatus, schedule maintenance, changing patterning recipe settings, etc. In order to measure properties of patterned structures on a substrate, metrology targets may be patterned as part of the patterning process of the substrate. The metrology targets, which may also be referred to as targets, may be provided with different designs, wherein the designs may be selected to measure specific properties of the patterned substrate.

One example type of measurement that will be described in more detail herein is measuring overlay based on images of metrology targets. Determining overlay between structures patterned in different steps of the patterning process may be based on images related to those structures. For image based overlay, a target may be provided on a substrate that comprises multiple non-overlapping structures (e.g. gratings) in different layers of interest. By measuring and/or comparing differences between the radiation that irradiated the targets in the different layers, property differences between the layers may be determined. In order to compare differences between targets using image based overlay, multiple images may be acquired, and the multiple images may be compared to determine the nature of similarities and/or differences. These multiple images may be obtained in a sequential acquisition, where images are obtained at different times, one after the other. An issue associated with comparing two or more sequentially acquired images is that it does not allow to distinguish between differences caused by properties of the target(s) and differences caused by time-dependent changes in the acquisition of the two or more different images. Such changes may for example include 3D vibrations of the substrate with respect to the optical sensor. Proposed herein are solutions for improving measurements, for example by reducing sensitivity to such three-dimensional vibrations of the substrate.

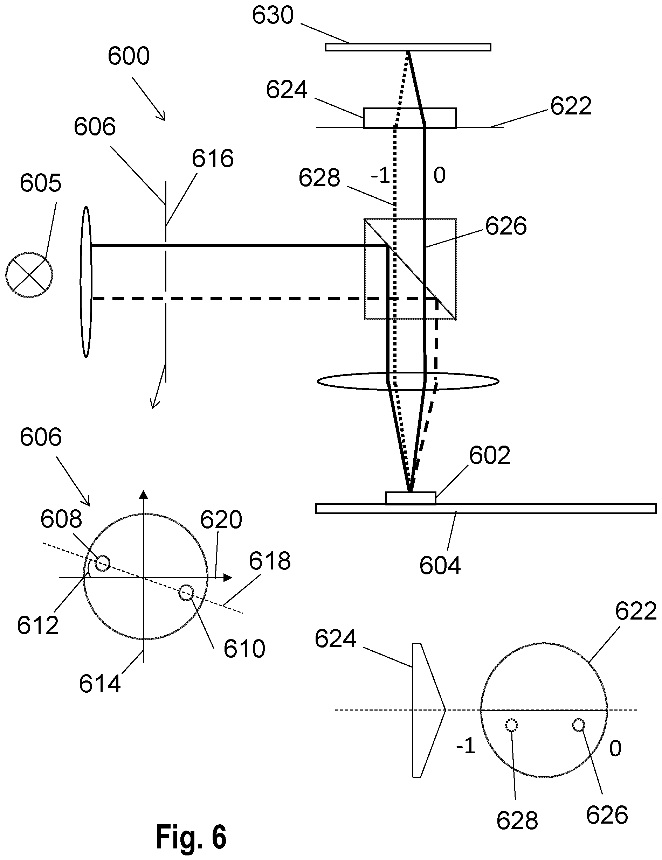

Described herein are methods and assemblies for measuring a structure, such as a metrology target, on a substrate. The assemblies disclosed herein relate to a multi-part wedge, wherein multi can be interpreted as two or more parts, and may include different numbers of parts to a wedge. While an assembly will initially be described in detail using a two-part wedge, an example of which is depicted in figure 6, wedges with different numbers of parts are also disclosed. While not depicted in a separate figure, assemblies comprising a six-part wedge and a four-part wedge will also be explicitly described, and may have corresponding features to the assembly depicted in figure 6. The descriptions of two-, four-, and six-part wedged are exemplary, and, while not described in detail herein, other numbers of parts to a multi-part wedge also form part of the disclosure of the multi-part wedge.

Described herein is an assembly 600 for determining a characteristic of a structure 602 on a substrate 604. Determining a characteristic may also be referred to as measuring a property of a structure 602 on a substrate 604. The assembly comprises a radiation illumination dipole 606 having a first source 608 and a second source 610. The first and second sources are angularly offset 612 relative to a longitudinal direction 614 and relative to a transverse direction 620 in an illumination plane 616. The first source 608 and the second source 610 are configured to irradiate the structure 602. The structure 602 has a periodically repeating pattern (a pitch) along the transverse direction 620 that is perpendicular to a longitudinal direction 614. A periodically repeating pattern along a transverse direction may for example comprise a line grating where the lines are parallel to the longitudinal direction 614.

The terms longitudinal direction and transverse direction are used throughout the description. These terms are provided to indicate an orientation relative to each other/other parts of an assembly, and are not intended to be limited to a specific orientation outside of the assembly. The longitudinal direction and the transverse direction may be perpendicular to each other. Both the longitudinal direction and the transverse direction may be present in planes of the system such as an entry pupil plane or an exit pupil plane or an imaging plane of the system. The longitudinal direction may be referred to as a Y-direction or a vertical direction, and the transverse direction may be referred to as an X-direction or a horizontal direction, for example in the example context of figures 6 - 12.

The assembly 600 has an exit pupil 622 comprising a multi-part wedge 624. The multi-part wedge is configured to receive, from the structure a lower radiation 626 order and a higher radiation order 628. The higher radiation order is of diffracted radiation. The higher order diffracted radiation may be a positive radiation order or negative radiation order. The term higher may refer to the absolute value of the order, and may ignore the positive or negative sign of the diffraction order. The lower radiation order of diffracted radiation may be zeroth order diffracted radiation, and may also comprise specular reflected radiation. The absolute value of the lower radiation order is smaller than the absolute value of the higher radiation order. In some instances, both the lower radiation order and the higher radiation order of diffracted radiation may be non-zeroth order diffracted radiation, for example first order diffracted radiation and second order diffracted radiation.

The multi-part wedge is configured to receive at least a significant portion (e.g. substantially all, more than 90%, more than 50%) of both a lower radiation order and a higher radiation order of diffracted radiation from the first source, and a lower radiation order and higher radiation order of diffracted radiation from the second source. The lower and higher radiation orders from the first source are received on one or more first parts of the multi-part wedge, and the lower and higher radiation orders from the second source are received on one or more second parts of the multipart wedge, wherein the one or more first parts and one or more second parts are non-overlapping.

While the multi-part wedge is described herein as being positioned in an exit pupil or exit pupil plane, it will be understood that a conjugate plane of an exit pupil would be an equivalent location for the functioning of the assembly. As the wedge has a non-zero thickness, it may in some instances be located near to an exit pupil plane. Alternatively, the multi-part wedge may be located in an entrance pupil of relay optics before the detector, which may be located in the detection path after interaction of the radiation with the substrate has occurred.

The assembly 600 further comprises a detector 630 configured to receive a first image on the detector formed from the first source radiation incident on the one or more first parts of the wedge. The detector is further configured to receive a second image formed from the second source radiation incident on the one or more second parts of the wedge. The first image and the second image are spatially separated on the detector. Spatially separated may be understood as each image comprising at least a portion that does not overlap with the other image. In some instances, the first image and the second image may be fully non-overlapping. In some instances, the first image and the second image may partially overlap. The overlapping portion may be less than 50%, or less than 30%, or less than 10% of each of the first image and the second image.

Figure 6 depicts a schematic representation of an assembly 600 for measuring a property of a structure 602 on the substrate 604. The measurement may comprise determining a characteristic of the structure. The characteristic may be overlay. The assembly as depicted in figure 6 comprises a radiation illumination dipole 606 comprising a first source 608 and a second source 610. The radiation illumination dipole 606 may be formed for example from a spatially incoherent or spatially coherent radiation source 605 and a blocking screen comprising two apertures for forming the first source 608 and second source 610. The first source 608 and the second source 610 are angularly 612 offset to a transverse direction 620 in an illumination pupil plane 616. The angular offset may be such that a line 618 passing through both the first source and the second source is neither parallel to the transverse direction 620 nor a longitudinal direction 614 perpendicular to the longitudinal direction. This may be expressed for example as an angle that is not 0 degrees, nor 90 degrees relative to the longitudinal direction. The first source and the second source are configured to irradiate the structure 602. The structure has a periodically repeating pattern along the transverse direction, perpendicular to the longitudinal direction (e.g. a line grating with lines along a longitudinal direction periodically repeated along the transverse direction).

The assembly disclosed herein further comprises an exit pupil 622 that comprises a multi-part wedge. In figure 6, the assembly comprises an exit pupil 622 that comprises a two-part wedge 624. A first part of the two-part wedge may be configured to receive from the structure, a specular reflected radiation order 626 (also referred to as $0^{th}$ order) of the first source, and one of a positive (+1) or negative (-1) first diffraction order 628 of radiation of the first source. A second part of the two-part wedge may be configured to receive from the structure, a specular reflected radiation order (also referred to as $0^{th}$ order) of the second source, and the other one of a positive (+1) or negative (-1) first diffraction order of radiation of the second source (second source radiation not shown in figure 6). In some implementations, the higher orders may be a positive and negative of a diffraction order higher than the first order. The first part of the two-part wedge may comprise a surface that is positioned at the nonzero angle relative to the surface of the second part of the two-part wedge. Each part of the two-part wedge may comprise a substantially planar surface. The first part of the two-part wedge and the second part of the two-part wedge may be divided along a dividing line. The dividing line may be perpendicular to the transverse direction of the repeating pattern of the structure. While the multi-part wedge described herein may comprise parts that have surfaced tilted relative to each other, it can be understood that other designs may be provided to direct radiation into different directions, such as for example metamaterials.

The assembly further comprises a detector 630 configured to receive a first image on the detector formed from the first source radiation incident on the first part of the wedge and a second image on the detector formed from the second source radiation incidents on the second part of the wedge. In some implementations, a plurality of detectors may be provided, where different detectors may be positioned to receive different images. The first image and the second image are spatially separated on the detector. Said differently, the detector is configured to receive radiation from the first part of the two-part wedge in a first area of the detector, and to receive radiation from the second part of the two-part wedge in a second area of the detector, wherein the first area and the second area on the detector comprise at least a non-overlapping portion. The first area and the second area may be fully non-overlapping or partially non-overlapping. An overlapping portion may be less than 50%, or less than 30%, or less than 10% of each of the first and second areas. The first image may comprise fringe patterns resulting from interference of the two radiation orders (0 and -1) incident on the first part of the two-part wedge. The second image may comprise fringe patterns resulting from interference of the two radiation orders (0 and +1) incident on the second part of the two-part wedge. It is noted that the zeroth orders for the two images may be physically different zeroth orders originating from different (first and second) sources. The different zeroth orders may originate from mutually incoherent monopoles of the illumination dipole.

Figure 6 depicts a negative first -1 diffraction order associated with the first source, and therefore has a positive first +1 order associated with the second source (not shown). It will be understood that a positive first +1 diffraction could also be used for the first source, which would lead to a negative first -1 diffraction order being captured for the second source. This may be achieved through alignment of the components and guiding of radiation orders in the assembly.

An advantage of an assembly as described above, is that the angularly offset dipole source enables radiation from the first and the second source to be directed from the target towards separate parts of the multi-part wedge. This may be referred to as a multi-channel metrology system. In case of a two-part wedge, the assembly may be referred to as a two-channel metrology system. The multi-part wedge can direct the radiation incident on its one or more first parts and one or more second parts in different first and second directions, meaning two separate images can be formed on the same detector (or multiple detectors) simultaneously. The first part(s) of the multi-part wedge may change the direction of incident radiation into one or more first directions. The second part(s) of the multi-part wedge may change the direction of incident radiation into one or more second directions, wherein the second directions differ from the first directions. In the case of a two-part wedge, for example, the first part of the wedge may direct radiation into the same first direction, and the second part of the wedge may direct radiation into the same second direction, wherein the first and the second directions are different from each other. The induced change of direction by the different parts of the wedge may lead to a displacement of the images to be formed by the two parts in to different directions. The change of direction may for example be through a linear phase offset, wherein the phase change linearly varies with respect to the position of incidence of the wedge. The phase change will also vary with the angle of the slope of the wedge (wedge angle). Since the wedge is located in or near the exit pupil plane (or a conjugate), this linear phase offset may lead to a lateral shift of the generated image. Any effects causing time-varying disturbances, such as 3D vibrations of the substrate, may be in common to both images formed on the detector, as the two images are obtained simultaneously. Therefore, their effects may be neutralised, depending on the chosen detector and assembly configuration. The resulting metrology assembly therefore may have a reduced sensitivity to time-varying effects of the detector configuration.

The methods and assemblies described herein provide a multi-channel, such as a two-channel, image-based measurement system that may enable robust overlay metrology in the presence of 3D vibrations of the substrate (e.g. vibrations of the stage holding the substrate), and/or the detector, and/or optical components of the assembly. The methods and assemblies may further provide robust measurement in the presence of other effects such as differences in diffraction phases between diffracting structures in different layers of the substrate.

The structure on the substrate may comprise a metrology target. The target may comprise at least two non-overlapping diffraction gratings. The two non-overlapping diffraction gratings may have been deposited during different patterning steps of the patterning process of the substrate. The two non-overlapping diffraction gratings may for example be located in different layers of the substrate. Having the non-overlapping gratings in different layers of the substrate may make the target suitable for measuring inter-layer overlay. In an alternative example, the two non-overlapping gratings may be located in the same layer, but have been deposited in separate process steps of the same layer (e.g. double patterning, quadruple patterning, half/split field imaging). In this instance, the target may be used to measure intra-layer overlay.

The diffraction gratings may comprise one-dimensional 1D diffraction gratings. The 1D diffraction grating may be a line grating, which may comprise multiple lines periodically arranged at a given pitch. Some or all of the two or more non-overlapping gratings may have substantially the same size (area on the substrate), substantially the same pitch (periodicity of the repeating structure), and/or substantially the same direction of the lines. The lines of a 1D diffraction grating may for example be oriented along the longitudinal direction, wherein the longitudinal direction and the transverse direction may both lie in the plane of the substrate. The substrate may be substantially planar, with different thin layers stacked on top of each other. The substrate and/or layer of the substrate may be referred to as having a 2D shape, wherein the dimensions of the substrate/layer are significantly larger in two dimensions, than in a third dimension normal to the plane of the substrate/layer. The diffraction gratings may be symmetrical gratings. The diffraction gratings may be subsegmented gratings. A grating line may be understood to have a finite length, a finite (non-zero) width, and a finite non-zero height. The height of the line may be dictated by the height of the sub-layer of the layer-stack in which the grating resides. While described as a line, the actual shape may approximate for example an elongated rectangle.

Combining an assembly with an angularly offset radiation illumination dipole and a multi-part wedge as described above with a target comprising two or more non-overlapping diffraction gratings has advantages specific to this combination. As described above, the simultaneous measurement of two images may result in largely reduced sensitivity to 3D vibrations of the stage on which the substrate resides, 3D vibration of the detector, and other time-varying effects. The provision of the non-overlapping diffraction structures enables the measurement of overlay by simultaneously imaging spatially separated effects from different layers. The resulting detected images may lead to significantly more robust inference of overlay characteristics of the substrate.

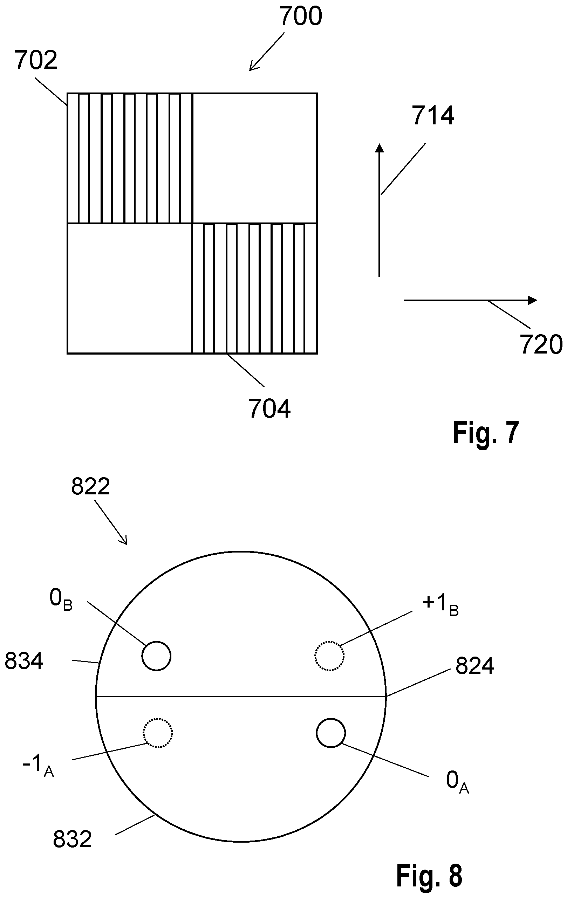

The assembly may measure separate images with fringe patterns from the non-overlapping diffraction structures. From these images they may derive relative fringe shifts of one fringe pattern with respect to another fringe pattern. Fringe shifts may for example be caused through interference of radiation from two or more reflection/diffraction orders. Fringes in images may be generated through interference of radiation from two or more different reflection and/or diffraction orders. The lateral shifts of these fringes may have various origins such as overlay, aberrations, vibrations, etc. While these fringe shifts will be described herein for diffraction patterns from 1D line gratings, different diffracting structure designs could also be used, and a corresponding analysis of their diffraction patterns may be performed. Figure 7 depicts a schematic representation of an example structure 700 comprising a target with non-overlapping structures. The target with non-overlapping structures may comprise a quadrant with first 702 and second 704 line gratings in equal-sized pads in the quadrant. The remaining two quarters of the quadrant may be left empty.

Alternatively, as described in more detail below, the remaining two quarters may be first with two additional line gratings oriented in an orthogonal direction to the gratings in the first two quarters. The gratings may be positioned diagonally opposed in the quadrant, for example in the top left and bottom right corners of the quad. The two gratings may be located in different layers of the substrate, for example with the top left pad grating patterned into a first layer referred to as a top layer, and the bottom right pad grating patterned into a second layer referred to as a bottom layer. The bottom layer may be positioned one or more layers (and/or processing steps) below the top layer in the stack of layers on the substrate. The diffraction grating may have periodically repeating grating lines parallel to a longitudinal direction 714. The pitch may be along the transverse direction 720.

Figure 8 depicts a schematic representation of different diffraction orders being incident on a two-part wedge 824 in the exit pupil 822. Radiation coming from the first source is indicated with a subscript A, and radiation coming from the second source is indicated with a subscript B. Radiation coming from the first source is shown as being incident on the first part 832 of the two-part wedge, which is depicted in the bottom half of Figure 8. Radiation coming from the second source is shown as being incident on the second part 834 of the two-part wedge, which is depicted in the top half of Figure 8. The first part 832 of two-part wedge 824 may receive specular reflected zeroth order radiation $0_A$, and the negative first diffracted radiation order $-1_A$. The second part 834 of the two-part wedge 824 may receive specular reflected zeroth order radiation

$0_B$, and the positive first diffracted radiation order $+1_B$. The signs of the first orders of the first source and the second source may be reversed as a matter of definition, such that they still maintain the opposite signs.

The diffraction gratings used in the structures may be line gratings. The lines of the diffraction grating of the target structure may be perpendicular to the division line of the two-part wedge. Said differently, the grating lines of a 1D diffraction grating may be orthogonal to the division line of the two-part wedge. By having this perpendicular orientation, the related zeroth specular reflected order and first diffraction order generated by the same one of the two sources will be positioned on the same part of the wedge. As a result, the different reflection/diffraction orders incident on the same part of the wedge can interfere at the detector, and a resulting fringe pattern may be detected.

An exit pupil may also be referred to as a detection pupil, an angular resolved plane of the detection branch, or a pupil plane defined by an objective that is present in the detection branch of the assembly. The features and elements of the assembly described in relation to a detection pupil, may also be provided in a conjugate plane of the detection pupil plane.

The description above refers to a two-part wedge, and two radiation sources from a radiation illumination dipole. The targets in this instance comprise 1D diffraction gratings with lines oriented along a direction perpendicular to the division line of the wedge. For the two-part wedge described in relation to figures 6 and 8 above, a 1D diffraction grating in a single direction allows overlay to be measured for that direction. A separate set-up having diffraction gratings in a perpendicular direction to the first gratings, and associated two-part wedge with a division line that is orthogonal to the division line of the first two-part wedge may be provided for measuring overlay in the transverse direction. Alternatively, this measurement may be achieved through a 90 degree angle rotation of the wedge relative to the substrate. A six-part wedge could also be provided, in which case overlay could be measured in the X direction and the Y direction (e.g. transverse and longitudinal) simultaneously in a single image. For such a six-part wedge, the diffracting structure may comprise a 2D diffraction structure, with periodically repeating patterns in both the X and Y directions. An example setup using a six-part wedge will be described below. A 2D diffracting structure may be used in a setup for a two-part wedge as well.

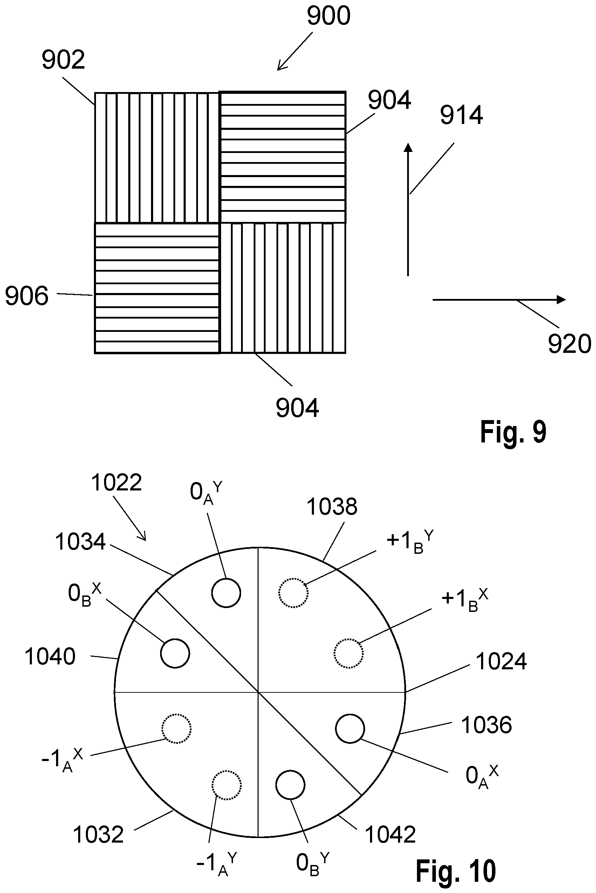

Figure 9 depicts a schematic representation of an example structure 900 comprising a target with non-overlapping structures. The target with non-overlapping structures may comprise a quadrant with a first pair of line gratings 902 and 904. The first pair of line gratings may be located in equal-sized pads in the quadrant. The first pair of line gratings may be located along a diagonal of the quadrant, diagonally opposed, for example in a top left corner and a bottom right corner of the quadrant. The target may further comprise a second pair of line gratings 906 and 908. The second pair of line gratings may be located in equal-sized pads in the quadrant. The size of the line gratings of the first pair may be equal to the size of the line gratings of the second pair. The second pair of line gratings may be located along a diagonal of the quadrant, diagonally opposed, for example in a bottom left corner and the top right corner of the quadrant.

The gratings in each pair may be located in different layers of the substrate. For example, grating 902 may be patterned into a first layer referred to as a top layer, and grating 90 for may be patterned into a second layer referred to as a bottom layer. The bottom layer may be positioned one or more layers (and/or processing steps) below the top layer in a stack of layers on the substrate. Correspondingly, for the second pair of gratings, grating 906 may be patterned into the first layer and grating 908 may be patterned into the second layer. Alternatively, in some implementations the second pair gratings may be patterned into a third layer and a fourth layer that may be different from the first layer and the second layer. The third layer and the fourth layer may also be a bottom layer and a top layer separated by one or more layers and/or processing steps. Providing that the two gratings forming part of the same pair are located in different layers, any combination of layers may be provided (e.g. first and second layers + third and fourth layers; first and third layers + second and third layers; first and second layers + second and third layers, second and third layers + first and third layers; etc.)

The gratings 902 and 904 in the first pair may have periodically repeating grating lines parallel to a longitudinal direction 914. The gratings 906 and 908 in the second pair may have periodically repeating grating lines parallel to a transverse direction 920. The longitudinal 914 and transverse 920 directions may also be referred to as the Y direction (e.g. depicted vertically in a figure) and the X direction (e.g. depicted horizontally in figure 9). The first pair of diffraction gratings 902 and 904 may be used to measure overlay in a transverse direction 920 (X-direction). The second pair of diffraction gratings 906 and 908 may be used to measure overlay in a longitudinal direction 914 (Y-direction). A quad comprising two sets of non-overlapping diffraction gratings, with the gratings in each set being oriented in a different direction, may allow for measurement of overlay in multiple directions simultaneously. While the structure depicted in figure 9 shows a quadrant with two sets of non-overlapping diffraction gratings in different layers/processing steps, it can be understood that sets with more than two diffraction gratings can also be used.

In order to be able to measure two pairs of diffraction gratings simultaneously, the exit pupil may have to capture more than the four radiation orders described in relation to a two-part wedge. Therefore, instead of using a two-part wedge as described in relation to figure 8 above, a six-part wedge may be provided. Figure 10 depicts a six-part wedge 1024, positioned at or near an exit pupil 1022. Such a six-part wedge may be provided in an assembly 600 as described in relation to Figure 6 above, by replacing the two-part wedge depicted in Figure 6. A six-part wedge may comprise six separate parts (which may be referred to as portions) oriented differently from at least their neighbouring parts. At least some of the parts in the six-part wedge may have different sizes. Each part of the six part wedge may be configured to receive at least one radiation order. The exemplary wedge depicted in Figure 10 may be separated into four quarters. Two of the diagonally

EP 4 749 366 A1

opposed quarters may further be separated in half, forming four eighths. Together with the two remaining diagonally opposed quarters and the four eighths may form the six parts of the six-part wedge. A group of three parts may be consist of one of the quarters, and the two eighths that do not directly neighbour the quarter of that group. For example, a first group of parts may be configured to receive radiation from the first source, and comprise a quarter part and two eighth parts. The second group of parts may be configured to receive radiation from the second source, and comprise the quarter part and two eighth parts that are diagonally opposed to their corresponding first parts.

Figure 10 depicts a six-part wedge in which, for the first source, a specular reflected radiation order $0_A{}^X$ from a first pair of structures may be incident on a first eighth of the first group of parts of the wedge. A first diffraction order, which may be a negative first diffraction order $-1_A{}^X$, may be incident on the quarter part of the first group of parts. A specular reflected radiation order from the second pair of structures $0_A{}^Y$ may be incident on the second eighth of the first part. A first diffraction order, which may be a negative first diffraction order $-1_A{}^Y$, may also be incident on the quarter of the first group of parts. Correspondingly, for the second source, a specular reflected radiation order from the first pair of structures $0_B{}^X$ may be incident on a first eighth of the second group of parts of the wedge. A first diffraction order, which may be a positive first diffraction order $+1_B{}^X$, may be incident on the quarter of the second group of parts. A specular reflected radiation order from the second pair of structures $0_B{}^Y$ may be incident on the second eighth of the second group of parts of the wedge. A first diffraction order, which may be a positive first diffraction order $+1_B{}^Y$, may also be incident on the quarter of the second group of parts. While in this example negative diffraction orders are described for the first source, and positive diffraction orders are described for the second source, this may also be reversed.

In this described example, radiation from the first source diffracted by the first pair of structures, and the second pair structures is incident on the first group of three parts of the wedge. Radiation from the second source diffracted by the first pair of structures and the second pair of structures is incident on the second group of three parts of the wedge. The first group of parts can direct radiation from the first source towards a first area on the detector, where interference fringes may be formed, as described in relation to a two-part wedge above. The images formed on the first area of the detector may comprise interference fringes from pairs of both transverse and longitudinal diffraction gratings. As a result the images in the first area can be used to determine overlay in both directions. Similarly, for the second group of parts, radiation can be directed from the second source towards a second area on the detector, where interference fringes may be formed. The images formed on the second area of the detector may comprise interference fringes from pairs of both transverse and longitudinal diffraction gratings. As a result, the images in the second area on the detector can be used to determine overlay in both X and Y directions. As the images in a first area and the second area may be obtained simultaneously, 3D vibrations, and other time-varying disturbances may be neutralised.

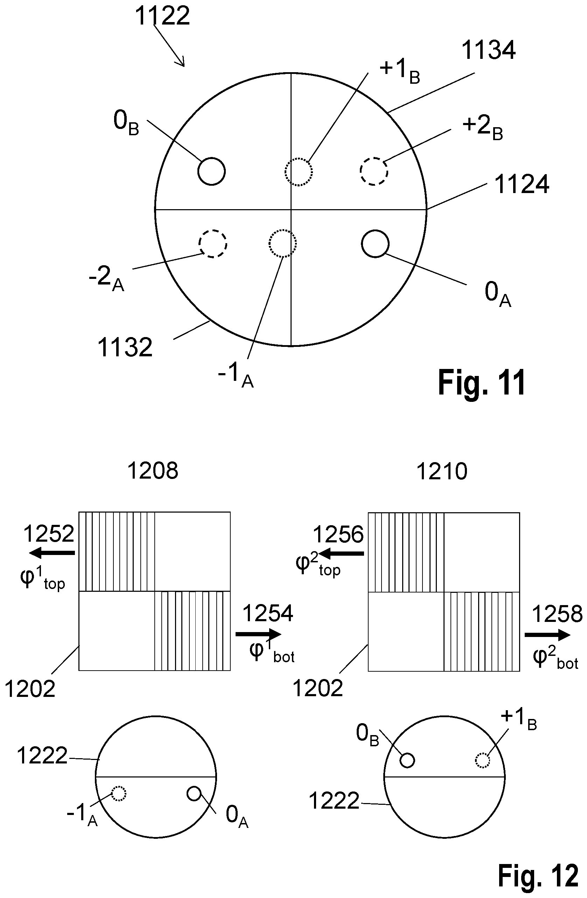

Figure 11 depicts an example of a four-part wedge 1124, which may be positioned in an exit pupil plane 1122. Grating structures and optical components may be provided such that two separate diffraction orders from the first source may be incident on a first quarter of the wedge 1132. The two diffraction orders may be a lower diffraction order and a higher diffraction order, such as for example a first diffraction order $-1_A$ and a second diffraction order $-2_A$ (positive or negative). Two separate diffraction orders from the second source may be incident on the second quarter of the wedge 1134. The second quarter 1134 of the wedge may be diagonally opposed to the first quarter of the wedge 1132. The two diffraction orders may be a lower diffraction order and a higher diffraction order, such as for example a first diffraction order $+1_B$ and a second diffraction order $+2_B$ (negative or positive, e.g. the opposite sign to the first source diffraction orders). This four-part wedge may also be provided in an exit pupil of an assembly as described herein, for example as depicted for example in figure 6. It is noted that the position of the radiation orders on the parts of the wedge as shown in figures 6, 8, 10, 11, and 12 are for illustrative purposes only, and the position of a radiation order may be in any region or area of the correct part of the multi-part wedge (e.g. centred, off-centre).

The first and the second sources may be located in the same illumination pupil plane. The optical axis may be perpendicular to the illumination pupil plane. The first source and second source may be located along a line that is angularly offset to both a longitudinal and transverse direction. The first source and the second source may be positioned point-symmetrically with respect to a centre of the illumination pupil of the illumination pupil plane. The optical axis may pass through the centre of the illumination pupil. The angular offset relative to the transverse direction may be less than 45 degrees. The angular offset may for example be in a range of 5 degrees to 20 degrees relative to the transverse direction. The first source and the second source may be formed by apertures in a blocking screen positioned in the illumination pupil plane. The blocking screen may be positioned in front of a radiation source. The radiation source may be spatially incoherent radiation source or a spatially partially coherent radiation source. The radiation source may be a wavelength tunable source. The radiation source may output one or more wavelengths in a range of 200 nm - 2000 nm, or one or more wavelengths in a range of 400 nm to 1600 nm, or one or more wavelengths in a range of 450 nm to 900 nm. The assemblies as described herein may also work for shorter wavelength ranges, e.g. down to 100 nm or lower. The radiation source may be configured to output small bandwidth radiation, also referred to as narrow bandwidth radiation. The first source and the second source may be first and second monopoles which may be derived from the same physical radiation source. The first source and the second source may comprise incoherent radiation. The first source and the second source may be mutually spatially incoherent. The first source and the second source may be approximated as incoherent monopoles.

The assembly may comprise a Fourier optics setup, such as a 4F optics setup, wherein the target structure on the substrate may be located in an input plane of the Fourier/4F optics setup. The two-part wedge may be located in a Fourier plane of the Fourier optics. The illumination pupil plane may be located in a conjugate plane of the Fourier plane. The detector may be located in output plane of the Fourier/ 4F optics. One or more objectives (lenses) may be shared between the illumination branch and a detection branch of the assembly.

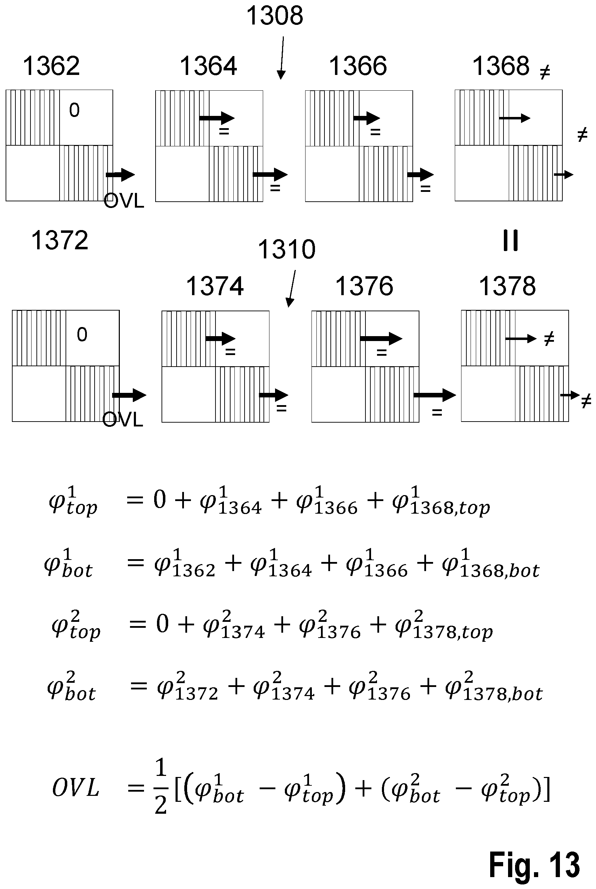

An example comprising a phenomenological argumentation of the functioning of assemblies and methods as described herein will now be provided in relation to Figure 12 and Figure 13. This explanation is provided as an illustrative example only, and the disclosure is not limited to the specific embodiment provided herein.

Figure 12 depicts a schematic representation of a target with non-overlapping structures being irradiated by a illumination dipole with an assembly as described herein, including a representation of the phase signals of the fringe patterns that are measured at the detector. The target may be a target structure comprising 2 non-overlapping 1D diffraction gratings having the same design (pitch, size, etc). The fringe patterns may be caused through interference of two reflection/diffraction orders incident on the same part of the two-part wedge. The left-hand side of Figure 12 depicts the effects of first radiation 1208 of the first source incident on the target structure 1202. This may for example be referred to as the first channel. Specular reflected radiation $0_A$ and negative first order diffracted radiation $-1_A$ may be directed onto the exit pupil 1022, on a bottom (first) part of the two-part wedge, forming part of the first channel of the assembly. The two radiation orders incident on the first part of the wedge may be directed towards a first area on the detector. The two radiation orders both originate from the first source, and may interfere, forming an interference pattern. This interference pattern may be referred to as fringes or fringe patterns. Each diffraction grating in the metrology target comprising non-overlapping gratings may lead to a separate fringe pattern. Referring to the diffraction gratings as top and bottom gratings, the first area of the detector is expected to detect a phase signal $\varphi^1_{top}$ 1252 associated with the top grating and the first source, and a phase signal $\varphi^1_{bot}$ 1254 associated with the bottom grating and the first source.

The right-hand side of Figure 12 depicts the effects of first radiation 1210 of the second source incident on the target structure 1202. This may for example be referred to as the second channel. Specular reflected radiation $0_B$ and positive first order diffracted radiation $+1_B$ may be directed onto the exit pupil 1222, on a top (second) part of the two-part wedge, forming part of the second channel of the assembly. The two radiation orders incident on the second part of the wedge may be directed towards a second area on the detector. The first area and the second area may be at least partially non-overlapping, and preferably fully non-overlapping. The two radiation orders on the top part of the wedge both originate from the second source, and may interfere to form fringe patterns. The second area of the detector may detect a phase signal $\varphi^2_{top}$ 1256 associated with the top grating and the second source, and a phase signal $\varphi^2_{bot}$ 1258 associated with the bottom grating and the second source.

Figure 13 depicts a schematic illustration of various contributions to the respective shifts of the four fringe patterns described above. The first row of contributions 1362, 1364, 1366, 1368 may originate from first radiation 1308. The second row of contributions 1372, 1374, 1376, 1378 may originate from the second radiation. Contributions to the phase signal of fringe patterns may include overlay 1362, 1372, aberrations 1364 1374, three-dimensional 3D vibrations 1366 1376, and phases of the complex-valued diffraction amplitudes 1368 1378. Overlay contributions 1362 and 1372 may be measured relative to each other. In this example the overlay of the top grating may be set to 0 (i.e. the reference), and any difference in the bottom layer may be the non-zero contribution to overlay, depicted as an arrow in 1362 and 1372. Any shifts to the four fringe patterns may be partly due to overlay as a parameter of interest, partly due to disturbances and non-ideal behaviour of the physical sensor.

As depicted in 1364, 1366, 1374, and 1376, the phase contributions induced by aberrations and 3D stage-vibrations may be the same between the top and bottom pads of the same target (due to the same radiation measuring both pads simultaneously and being subjected to the same disturbances such as 3D stage vibrations), and these contributions to the fringe patterns may will therefore be cancelled out by subtraction of the bottom- and top-phases (for each of the two channels). A phase offset as introduced by the complex-valued diffraction amplitudes of 0th and $\pm$1st orders are typically different for top-layer and bottom-layer gratings. This may be because of multiple reasons (e.g. layer-stack in between, different profiles, one grating in resist, the other grating being etched with other processing steps involved, different constituent materials generating the optical contrast, ...).

The diffraction gratings in the top pad and bottom pad may be symmetric gratings, for which the amplitudes and the phases may be identical upon sign inversion from +1 to -1 diffraction orders. Said otherwise, these phases may be assumed to be independent of the specific channel. Therefore, while the effect of the top pad and the bottom pad for the same channel (radiation source) do not cancel each other out, the top pad from the first source and the top pad from the second source may be cancelled out through addition of the phase differences by subtracting the phase of the bottom grating from the phase of the top grating for the two channels. This may be because the diffraction phases for the two channels (with 0 and +1 orders interfering for the one channel and -1 and 0 orders interfering for the other channel) may contribute with equal in magnitude but with opposite signs. Similarly, the bottom pad of the first source and the bottom pad of the second source may have the same phase contribution. In such case, these diffraction effects may be cancelled out by the effective addition of the respective phase differences for the two channels. If the gratings are not symmetric, a separate measurement may be performed to determine the asymmetry, and this may be included in the calculation for the signals cancelling each other out.

The 4 fringe patterns that can be detected on the detector from the images of the first and second channels comprises the following contributions:

$$\varphi^1_{top} = 0 + \varphi^1_{1364} + \varphi^1_{1366} + \varphi^1_{1368,\,top} \tag{1}$$

$$\varphi^1_{bot} = \varphi^1_{1362} + \varphi^1_{1364} + \varphi^1_{1366} + \varphi^1_{1368,\,bot} \tag{2}$$

$$\varphi^2_{top} = 0 + \varphi^2_{1374} + \varphi^2_{1376} + \varphi^2_{1378,\,top} \tag{3}$$

$$\varphi^2_{bot} = \varphi^2_{1372} + \varphi^2_{1374} + \varphi^2_{1376} + \varphi^2_{1378,\,bot} \tag{4}$$

As stated above, the phase signal contributions 1362 and 1372 may represent overlay, which may be an overlay value with a known offset to account for the non-overlapping nature of the gratings. This known offset can trivially be compensated for. Therefore it follows from the cancellations between different contributions of disturbances described above, that overlay may be determined from the 4 measured fringe signals formed on the detector as follows:

$$OVL = \tfrac{1}{2}\left[\left(\varphi^1_{bot} - \varphi^1_{top}\right) + \left(\varphi^2_{bot} - \varphi^2_{top}\right)\right] = \tfrac{1}{2}\left(\varphi^1_{1362} + \varphi^2_{1372}\right) \tag{5}$$

In the above equation, overlay may be expressed in unit of radians. A pitch scaling may be performed to express overlay in a nanometer or meter unit.

Provided below is a mathematical signal analysis for a 2-channel measurement assembly using a target with non-overlapping structures as in the example described in relation to figures 12 and 13 above. 4 complex-valued phase signals are created through interference of the zeroth specular reflected order with the positive or negative first diffraction order (2D positions in the exit pupil). The letters a and b may be used to indicate the 2 detector branches (i.e. channels) related to radiation of the first "a" (a can also be denoted as +) and second "b" (b can also be denoted as -) sources of the radiation illumination dipole. "Top" and "Bot" pads p may be used to specifically refer to a diffraction grating of the target residing in the top layer (e.g. located in the top left corner) or residing in the bottom layer (e.g. located in the bottom right corner). The overlay may be fully attributed to the bottom layer (as overlay is a value determined relative to a reference, and the reference may be chosen as the top layer). An overall 2D position offset (or, alignment offset) of the target may be denoted by $\Delta x_{A1}$ (orthogonal to the grating lines). Further note that both $\Delta x_{A1}$ and overlay OVL may be dimensionless scaled versions of their raw counterparts through multiplication with the scaling factor $2\pi$/pitch. Pitch may be understood to be the period of the line grating. For the first (a) detection branch, for each of the two pads indicated by the subscript p (= top, bot), a signal is provided which is the +1st Fourier component of the image intensity. The phase of this signal may be used for the inference of overlay, since this phase may represent a shift of the fringe-pattern. The 2D vectors may denote the positions of the diffraction orders in the respective exit pupils:

$$S^a_p = \left(E^{a1}_p\right)\left(E^{a0}_p\right)^* e^{i\Delta x_{Al}} e^{ipOVL} e^{+2\pi i\left[\chi^{2D}(\rho_{a1}) - \chi^{2D}(\rho_{a0})\right]} \mu(\rho_{a1}, \rho_{a0}) \tag{6}$$

And similarly for the second (b) detection branch there is a signal (taking into account the proper order of the interfering diffraction orders to generate a +1 Fourier component of the image intensity):

$$S^b_p = \left(E^{b0}_p\right)\left(E^{b1}_p\right)^* e^{i\Delta x_{Al}} e^{ipOVL} e^{-2\pi i\left[\chi^{2D}(\rho_{b1}) - \chi^{2D}(\rho_{b0})\right]} \mu(\rho_{b0}, \rho_{b1}) \tag{7}$$

Note that the 0th orders for the first and second channels may be physically different for the two branches (e.g. because of their location in the entrance pupil, and at 2 opposite sides of the 2-fold wedge in the plane of the exit pupil). The two zeroth orders may be located at symmetric points with respect to the center of the exit pupil as a result of them being located at symmetric points with respect to the entrance pupil. The amplitude of the two zeroth orders may be different, as the method uses a comparison of the phase of the interference signal, and not the amplitude. The difference between the zeroth orders has been indicated with an explicit sign before the "0" (a or b). The signal may comprise factors related to diffraction (pad-dependent), linear phase-shift (partially pad-dependent because overlay may be accounted fully by the shift of the bottom grating in its respective pad), aberrations (pad-independent), and 3D vibrations (pad-independent). 3D vibrations may lead to the complex-valued factor denoted by μ. For the factor μ, attention should be paid to the order of interference of the diffraction orders.

The phases of these signals may be written as in the equations provided below. $DP_p$ may indicate a so-called diffraction phase. A diffraction phase may be related to the first two factors of the signals (6) and (7) above. The first two factors may be associated with the complex valued diffraction amplitudes of the interfering diffraction orders.

$$phase\left[S_p^a\right] = DP_p^{a1} - DP_p^{a0} + (\Delta x_{Al} + po) + 2\pi[\chi^{2D}(\rho_{a1}) - \chi^{2D}(\rho_{a0})] + phase[\mu(\rho_{a1}, \rho_{a0})]$$

$$phase\left[S_p^b\right] = DP_p^{b0} - DP_p^{b1} + (\Delta x_{Al} + po) - 2\pi[\chi^{2D}(\rho_{b1}) - \chi^{2D}(\rho_{b0})] + phase[\mu(\rho_{b0}, \rho_{b1})]$$

The phase difference between the top and bottom pads for the first (a) branch may be calculated as:

$$\Delta_p phase\left[S_p^a\right] = phase\left[S_{p=bot}^a\right] - phase\left[S_{p=top}^a\right]$$

$$= DP_{p=bot}^{a1} - DP_{p=bot}^{a0} - DP_{p=top}^{a1} + DP_{p=top}^{a0} + OVL$$

$$= OVL + \Delta DP_{p=bot}^a - \Delta DP_{p=top}^a$$

The phase difference between the top and bottom pads for the second (b) branch may be calculated as:

$$\Delta_p phase\left[S_p^b\right] = phase\left[S_{p=bot}^b\right] - phase\left[S_{p=top}^b\right]$$

$$= DP_{p=bot}^{b0} - DP_{p=bot}^{b1} - DP_{p=top}^{b0} + DP_{p=top}^{b1} + OVL$$

$$= OVL - \Delta DP_{p=bot}^b + \Delta DP_{p=top}^b$$

Wherein a pad-based phase difference between the 0th and first order for the two channels is denoted as:

$$\Delta DP_p^{a \backslash b} = DP_p^{a \backslash b1} - DP_p^{a \backslash b0}$$

By taking a difference of these pad-based signals, all pad-independent terms in the respective phases may be eliminated. This step cancelled out the overall alignment $\Delta x_{A1}$, aberrations, and vibration induced phase offsets (i.e. 3D vibrations).

If the gratings are assumed to be symmetric, the following applies: $\Delta DP_p^a = \Delta DP_p^b$. If the gratings are not symmetric an extra step for measuring the asymmetry may be required. Regarding the final step, overlay may be obtained as an average of the pad-based phase difference for the first and second channels:

$$OVL = \frac{1}{2}(\Delta_p phase\left[S_p^a\right] + \Delta_p phase\left[S_p^b\right])$$

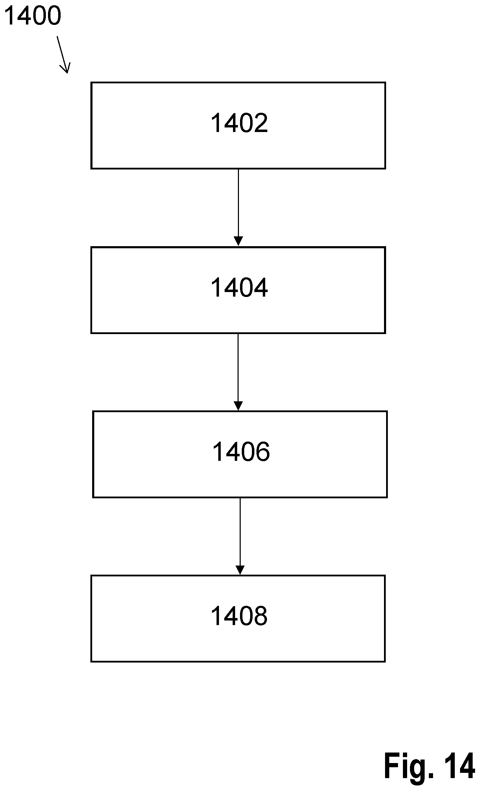

Figure 14 depicts a flow chart of steps in a method 1400 for determining a characteristic such as overlay of a structure on a substrate. Radiation is received 1402 from a radiation illumination dipole comprising a first source and a second source. The first source and the second source are angularly offset to a longitudinal direction in an illumination pupil plane. The first source and the second source irradiate 1404 the structure, which has periodically repeating patterns along a transverse direction that is perpendicular to the longitudinal direction. After irradiating the structure, radiation is received 1406 at an exit pupil comprising a multi-part wedge. The radiation comprises a lower radiation order and a higher radiation order of diffracted radiation of the first source, on one or more first parts of the multi-part wedge, and a lower radiation order and a higher radiation order of diffracted radiation of the second source, on one or more second parts of the multi-part wedge. A detector detects 1408 a first image on the detector formed from the first source radiation incident on the one or more first parts of the multi-part wedge, and a second image on the detector formed from the second source radiation incident on the one or more second parts of the multi-part wedge. The first image and the second image may be spatially separated on the detector. This may be because the first parts and the second parts of the multi-part wedge have directed the radiation incident on the one or more first parts and second parts of the wedge into different directions for the first part(s) and the second part(s), respectively. The first image may comprise fringe patterns formed through interference of the specular reflected radiation and the first order diffracted radiation on the first part of the two-part wedge. The second image may comprise fringe patterns formed through interference of the specular reflected radiation and the first order diffracted radiation on the second part of the two-part wedge.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

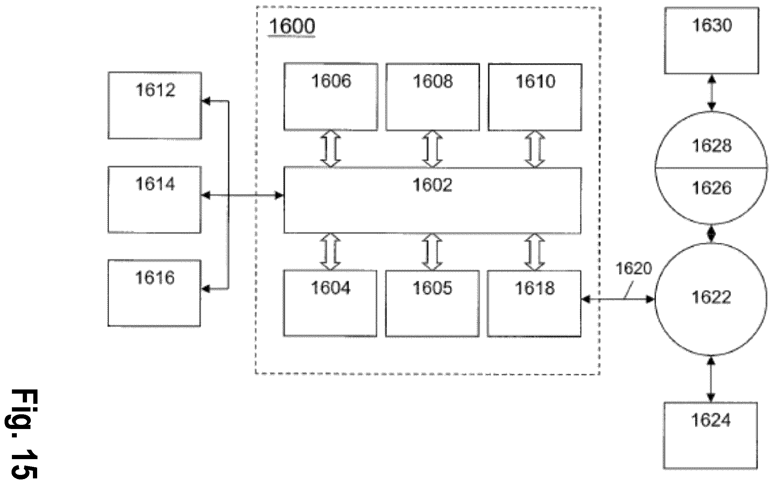

Figure 15 is a block diagram that illustrates a computer system 1600 that may assist in implementing the methods and flows disclosed herein. Computer system 1600 includes a bus 1602 or other communication mechanism for communicating information, and a processor 1604 (or multiple processors 1604 and 1605) coupled with bus 1602 for processing information. Computer system 1600 also includes a main memory 1606, such as a random access memory (RAM) or other dynamic storage device, coupled to bus 1602 for storing information and instructions to be executed by processor 1604. Main memory 1606 also may be used for storing temporary variables or other intermediate information during execution of instructions to be executed by processor 1604. Computer system 1600 further includes a read only memory (ROM) 1608 or other static storage device coupled to bus 1602 for storing static information and instructions for processor 1604. A storage device 1610, such as a magnetic disk or optical disk, is provided and coupled to bus 1602 for storing information and instructions.

Computer system 1600 may be coupled via bus 1602 to a display 1612, such as a cathode ray tube (CRT) or flat panel or touch panel display for displaying information to a computer user. An input device 1614, including alphanumeric and other keys, is coupled to bus 1602 for communicating information and command selections to processor 1604. Another type of user input device is cursor control 1616, such as a mouse, a trackball, or cursor direction keys for communicating direction information and command selections to processor 1604 and for controlling cursor movement on display 1612. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1600 in response to processor 1604 executing one or more sequences of one or more instructions contained in main memory 1606. Such instructions may be read into main memory 1606 from another computer-readable medium, such as storage device 1610. Execution of the sequences of instructions contained in main memory 1606 causes processor 1604 to perform the process steps described herein. One or more processors in a multi-processing arrangement may also be employed to execute the sequences of instructions contained in main memory 1606. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1604 for execution. Such a medium may take many forms, including but not limited to, non-volatile media, volatile media, and transmission media. Non-volatile media include, for example, optical or magnetic disks, such as storage device 1610. Volatile media include dynamic memory, such as main memory 1606. Transmission media include coaxial cables, copper wire and fiber optics, including the wires that comprise bus 1602. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1604 for execution. For example, the instructions may initially be borne on a magnetic disk of a remote computer. The remote computer can load the instructions into its dynamic memory and send the instructions over a telephone line using a modem. A modem local to computer system 1600 can receive the data on the telephone line and use an infrared transmitter to convert the data to an infrared signal. An infrared detector coupled to bus 1602 can receive the data carried in the infrared signal and place the data on bus 1602. Bus 1602 carries the data to main memory 1606, from which processor 1604 retrieves and executes the instructions. The instructions received by main memory 1606 may optionally be stored on storage device 1610 either before or after execution by processor 1604.

Computer system 1600 also preferably includes a communication interface 1618 coupled to bus 1602. Communication interface 1618 provides a two-way data communication coupling to a network link 1620 that is connected to a local network 1622. For example, communication interface 1618 may be an integrated services digital network (ISDN) card or a modem to provide a data communication connection to a corresponding type of telephone line. As another example, communication interface 1618 may be a local area network (LAN) card to provide a data communication connection to a compatible LAN. Wireless links may also be implemented. In any such implementation, communication interface 1618 sends and receives electrical, electromagnetic or optical signals that carry digital data streams representing various types of information.

Network link 1620 typically provides data communication through one or more networks to other data devices. For example, network link 1620 may provide a connection through local network 1622 to a host computer 1624 or to data equipment operated by an Internet Service Provider (ISP) 1626. ISP 1626 in turn provides data communication services through the worldwide packet data communication network, now commonly referred to as the "Internet" 1628. Local network 1622 and Internet 1628 both use electrical, electromagnetic or optical signals that carry digital data streams. The signals through the various networks and the signals on network link 1620 and through communication interface 1618, which carry the digital data to and from computer system 1600, are exemplary forms of carrier waves transporting the information.

Computer system 1600 may send messages and receive data, including program code, through the network(s), network link 1620, and communication interface 1618. In the Internet example, a server 1630 might transmit a requested code for an application program through Internet 1628, ISP 1626, local network 1622 and communication interface 1618. One such downloaded application may provide for one or more of the techniques described herein, for example. The received code may be executed by processor 1604 as it is received, and/or stored in storage device 1610, or other non-volatile storage for later execution. In this manner, computer system 1600 may obtain application code in the form of a carrier wave.

Further embodiments are disclosure in the subsequent list of numbered clauses:

1. An assembly for determining a characteristic of a structure on a substrate, the assembly comprising:

a radiation illumination dipole comprising a first source and a second source, wherein the first source and the second source are angularly offset to a transverse direction in an illumination pupil plane, and wherein the first source and the second source are configured to irradiate the structure, the structure having a periodically repeating pattern along the transverse direction;
an exit pupil comprising a multi-part wedge configured to receive from the structure:

a lower radiation order and a higher radiation order of diffracted radiation of the first source on one or more first parts of the multi-part wedge; and
a lower radiation order and a higher radiation order of diffracted radiation of the second source on one or more second parts of the multi-part wedge; and

a detector configured to receive a first image on the detector formed from the first source radiation incident on the one or more first parts of the wedge and a second image on the detector formed from the second source radiation incident on the one or more second parts of the wedge, wherein the first image and the second image are spatially separated on the detector.

2. An assembly according to clause 1, in which the first image and the second image are formed simultaneously.
3. An assembly according to any of the preceding clauses, wherein the characteristic to be measured is overlay.
4. An assembly according to any of the preceding clauses, wherein the structure comprises a metrology target.
5. An assembly according to any of the preceding clauses, wherein the multi-part wedge is a two-part wedge.
6. An assembly according to clause 5, wherein the lower radiation order of the first source is a specular reflected radiation order and the higher radiation order of the first source is one of a positive or negative first order diffracted radiation; and

wherein the lower radiation order of the second source is a specular reflected radiation order and the higher radiation order of the second source is the other one of a positive or negative first order diffracted radiation.

7. An assembly according to any of clauses 5-6, wherein the first part of the two-part wedge and the second part of the two-part wedge are divided along a line that is parallel to the transverse direction of the repeating pattern of the structure.

8. An assembly according to any of clauses 5-7, wherein the first part of the two-part wedge changes direction of incident radiation in one or more first directions, and the second part of the two-part wedge changes direction of the incident radiation in one or more second directions, wherein the first directions and the second directions are different.

9. An assembly according to any of clauses 1 - 4, wherein the multi-part wedge is a six-part wedge, and wherein the structure comprises a further periodically repeating pattern along a longitudinal direction that is perpendicular to the transverse direction.

10. An assembly according to clause 9, wherein the exit pupil is configured to receive, from the structure:

a specular reflected radiation and one of a positive or negative first order diffracted radiation from the periodically repeating pattern along the transverse direction and a specular reflected radiation and one of a positive or negative first order diffracted radiation from the periodically repeating pattern along the longitudinal direction of the first source on two or more first parts of the six-part wedge; and

a specular reflected radiation and the other one of a positive or negative first order diffracted radiation from the periodically repeating pattern along the transverse direction and a specular reflected radiation and the other one of a positive or negative first order diffracted radiation from the periodically repeating pattern along the longitudinal direction of the first source on two or more second parts of the six-part wedge.

11. An assembly according to any of clauses 9 - 10, wherein the first parts of the wedge comprise two or more separate portions of the wedge configured to send radiation in a first direction towards the first part of the detector; and the second parts of the wedge comprises a second group of two or more separate portions of the wedge configured to send radiation in a second direction towards the second part of the detector.

12. An assembly according to clause 11, wherein the two or more separate portions of the first group are separated by the two or more separate portions of the second group.

13. An assembly according to any of clauses 11 - 12, wherein the first parts comprise three parts, including a part having a quarter size, and two diagonally opposing parts having an eighth-size, the two diagonally opposing parts located in quarters next to the quarter-size wedge and not touching the quarter-size part of the first parts; and the second parts comprise three parts, including a part having a quarter size, and two diagonally opposing parts having an eighth-size, the two diagonally opposing parts located in quarters next to the quarter-size part, wherein the quarter size part of the first group is diagonally opposed to the quarter size wedge of the second group.

14. An assembly according to any of clauses 1-4, wherein the multi-part wedge is a four-part wedge.

15. An assembly according to clause 14, wherein the lower radiation order and the higher radiation order from the first source are incident on a same quarter on the first part of the wedge; and wherein the lower radiation order and the higher radiation order from the second source are incident on a same quarter on the second part of the wedge.

16. An assembly according to any of the preceding clauses, wherein the assembly is configured to measure a structure that comprises at least two non-overlapping diffraction gratings.

17. An assembly according to clause 16, wherein the two non-overlapping diffraction gratings have a same size, pitch, and direction.

18. An assembly according to any of clauses 16 or 17, wherein the non-overlapping diffraction gratings are line gratings having lines along a longitudinal direction that is perpendicular to the transverse direction.

19. An assembly according to any of clauses 16 - 18, wherein the non-overlapping gratings are located in different layers of the substrate.

20. An assembly according to any of the preceding clauses, wherein the multi-part wedge covers the exit pupil of the assembly.

21. An assembly according to any of clauses 5 - 13, wherein the assembly is configured to measure a structure that comprises at least two pairs of non-overlapping diffraction gratings.

22. An assembly according to clause 21, wherein the gratings in a pair of non-overlapping diffraction gratings have the same size and pitch.

23. An assembly according to clause 21 or 22, wherein a first pair of diffraction gratings has lines in a longitudinal direction perpendicular to the transverse direction, and a second pair of diffraction gratings has lines in the transverse direction.

24. An assembly according to any of clauses 21 - 23, wherein the non-overlapping gratings in a pair are located in different layers of the substrate.

25. An assembly according to any of clauses 21 to 24, wherein the structure comprises a first pair of non-overlapping gratings positioned on a first diagonal of a square, and a second pair of non-overlapping grating positioned on a second diagonal of the square.

26. An assembly according to any of the preceding clauses, wherein the first source and the second source are angularly offset to both the transverse direction and a longitudinal direction perpendicular to the transverse direction in the illumination pupil plane.

27. An assembly according to any of the preceding clauses, wherein the first source and the second source are positioned point-symmetrically with respect to a center of an illumination pupil in the illumination pupil plane.

28. An assembly according to any of the preceding clauses, wherein the angular offset is less than 45 degrees relative to the transverse direction.

29. An assembly according to any of the preceding clauses, wherein the angular offset is in a range of 5 degrees to 20 degrees relative to the transverse direction.

30. An assembly according to any of the preceding clauses, wherein the first source and the second source are formed by apertures in a blocking screen located in the illumination pupil plane in front of a radiation source.

31. An assembly according to any of the preceding clauses, wherein the radiation source is a spatially incoherent radiation source.

32. An assembly according to any of clauses 29 - 31, wherein the radiation source is a tunable source with wavelengths in a range of 200 nm - 2000 nm.

33. An assembly according to any of clauses 29 - 32, wherein the radiation source is configured to output small bandwidth radiation.

34. An assembly according to any of the preceding clauses, wherein the first source and the second source comprise incoherent radiation.

35. An assembly according to clause 34, wherein the first source and the second source are mutually incoherent.

36. An assembly according to any of the preceding clauses, wherein the assembly comprises a 4F optics setup.

37. An assembly according to clause 36, further comprising a substrate support for holding the substrate comprising the structure, wherein the substrate support is located in an input plane of the 4F optics optics, the multi-part wedge is located in a Fourier plane of the 4F optics setup, and the detector is located in an output plane of the 4F optics setup.

38. A method for determining a characteristic of a structure on a substrate, the method comprising:

receiving radiation from a radiation illumination dipole comprising a first source and a second source, wherein the first source and the second source are angularly offset to a transverse direction in an illumination pupil plane, irradiating, by the first source and the second source, the structure, the structure having a periodically repeating pattern along the transverse direction;

receiving, at an exit pupil comprising a multi-part wedge:

a lower radiation order and a higher radiation order of diffracted radiation of the first source on a first part of the multi-part wedge; and
a lower radiation order and a higher radiation order of diffracted radiation of the second source on a second part of the multi-part wedge;

detecting, by a detector, a first image on the detector formed from the first source radiation incident on the first part of the wedge and a second image on the detector formed from the second source radiation incident on the second part of the wedge, wherein the first image and the second image are spatially separated on the detector.

39. A method according to clause 38, wherein the first image comprises a first diffraction pattern formed by the lower radiation order and the higher radiation order of the first source, and the second image comprises a second diffraction pattern formed from interaction of the lower radiation order and the higher radiation order of the second source.

40. A method according to any of clauses 38 - 39, further comprising comparing the first image and the second image to determine a relative phase difference between the diffraction patterns.

41. A method according to any of clauses 38 - 40, further comprising determining overlay of the structure on the substrate based on analysis of the first image and the second image.

42. An apparatus comprising an assembly according to any of clauses 1 - 37.

43. A system comprising an assembly according to any of clauses 1 - 37.

44. A system according to clause 43, further comprising a structure, the structure comprising at least two non-overlapping diffraction gratings.

45. A system according to clause 44, wherein the non-overlapping diffraction gratings are line gratings having lines along a longitudinal direction perpendicular to the transverse direction.

46. A system according to any of clauses 44 - 45, wherein the non-overlapping gratings are located in different layers of the substrate.

47. A metrology apparatus comprising an assembly according to any of clauses 1-37.

48. An inspection apparatus comprising an assembly according to any of clauses 1-37.

49. A lithographic apparatus comprising an assembly according to any of clauses 1 - 37.

50. A litho cell comprising an apparatus according to any of clauses 42, or 47 - 49.

## Claims

1. An assembly for determining a characteristic of a structure on a substrate, the assembly comprising:

   a radiation illumination dipole comprising a first source and a second source, wherein the first source and the second source are angularly offset to a transverse direction in an illumination pupil plane, and wherein the first source and the second source are configured to irradiate the structure, the structure having a periodically repeating pattern along the transverse direction;
   an exit pupil comprising a multi-part wedge configured to receive from the structure:

   a lower radiation order and a higher radiation order of diffracted radiation of the first source on one or more first parts of the multi-part wedge; and
   a lower radiation order and a higher radiation order of diffracted radiation of the second source on one or more second parts of the multi-part wedge; and

   a detector configured to receive a first image on the detector formed from the first source radiation incident on the one or more first parts of the wedge and a second image on the detector formed from the second source radiation incident on the one or more second parts of the wedge, wherein the first image and the second image are spatially separated on the detector.

2. An assembly according to claim 1, in which the first image and the second image are formed simultaneously.

3. An assembly according to any of the preceding claims, wherein the multi-part wedge is a two-part wedge.

4. An assembly according to claim 3, wherein the lower radiation order of the first source is a specular reflected radiation order and the higher radiation order of the first source is one of a positive or negative first order diffracted radiation; and wherein the lower radiation order of the second source is a specular reflected radiation order and the higher radiation order of the second source is the other one of a positive or negative first order diffracted radiation.

5. An assembly according to any of claims 3-4, wherein the first part of the two-part wedge and the second part of the two-part wedge are divided along a line that is parallel to the transverse direction of the repeating pattern of the structure.

6. An assembly according to any of claims 3-5, wherein the first part of the two-part wedge changes direction of incident radiation in one or more first directions, and the second part of the two-part wedge changes direction of the incident radiation in one or more second directions, wherein the first directions and the second directions are different.

7. An assembly according to any of claims 1 - 2, wherein the multi-part wedge is a six-part wedge, and wherein the structure comprises a further periodically repeating pattern along a longitudinal direction that is perpendicular to the transverse direction.

8. An assembly according to any of claims 1 - 2, wherein the multi-part wedge is a four-part wedge.

9. An assembly according to any of the preceding claims, wherein the assembly is configured to measure a structure that comprises at least two non-overlapping diffraction gratings.

10. An assembly according to any of the preceding claims, wherein the multi-part wedge covers the exit pupil of the assembly.

11. An assembly according to any of the preceding claims, wherein the first source and the second source are angularly offset to both the transverse direction and a longitudinal direction perpendicular to the transverse direction in the illumination pupil plane.

12. An assembly according to any of the preceding claims, wherein the first source and the second source are positioned point-symmetrically with respect to a center of an illumination pupil in the illumination pupil plane.

13. An assembly according to any of the preceding claims, wherein the first source and the second source are formed by apertures in a blocking screen located in the illumination pupil plane in front of a radiation source.

14. A method for determining a characteristic of a structure on a substrate, the method comprising:

receiving radiation from a radiation illumination dipole comprising a first source and a second source, wherein the first source and the second source are angularly offset to a transverse direction in an illumination pupil plane, irradiating, by the first source and the second source, the structure, the structure having a periodically repeating pattern along the transverse direction;
receiving, at an exit pupil comprising a multi-part wedge:

a lower radiation order and a higher radiation order of diffracted radiation of the first source on a first part of the multi-part wedge; and
a lower radiation order and a higher radiation order of diffracted radiation of the second source on a second part of the multi-part wedge;

detecting, by a detector, a first image on the detector formed from the first source radiation incident on the first part of the wedge and a second image on the detector formed from the second source radiation incident on the second part of the wedge, wherein the first image and the second image are spatially separated on the detector.

15. A metrology apparatus comprising an assembly according to any of claims 1-13.

# Fig. 1

# Fig. 2

LC

SC x 4

SCS

I/O1

BK  CH  RO

BK  CH

LACU

TCU  LB  LA

I/O2

CH  BK

CH  BK

DE x 4

# Fig. 3

LA

SC1

0
-1      +1

CL

SC2

MT

SC3

**Fig. 4**

**Fig. 5**

**Fig. 6**

700

702

714

720

Fig. 7

822

$0_B$

$+1_B$

834

824

$-1_A$

$0_A$

832

Fig. 8

900

902

904

906

904

914

920

**Fig. 9**

1022

$0_A{}^Y$

1038

$+1_B{}^Y$

1034

$0_B{}^X$

$+1_B{}^X$

1040

1024

$-1_A{}^X$

1036

1032

$0_A{}^X$

$-1_A{}^Y$

$0_B{}^Y$

1042

**Fig. 10**

1122

0_B    +1_B    1134

+2_B

1124

-2_A    -1_A    0_A

1132

**Fig. 11**

1208    1210

1252    1256
$\varphi^1_{top}$    $\varphi^2_{top}$

1254    1258
$\varphi^1_{bot}$    $\varphi^2_{bot}$

1202    1202

1222    0_B    +1_B

-1_A    0_A    1222

**Fig. 12**

Fig. 13

$$\varphi_{top}^1 \quad = 0 + \varphi_{1364}^1 + \varphi_{1366}^1 + \varphi_{1368,top}^1$$

$$\varphi_{bot}^1 \quad = \varphi_{1362}^1 + \varphi_{1364}^1 + \varphi_{1366}^1 + \varphi_{1368,bot}^1$$

$$\varphi_{top}^2 \quad = 0 + \varphi_{1374}^2 + \varphi_{1376}^2 + \varphi_{1378,top}^2$$

$$\varphi_{bot}^2 \quad = \varphi_{1372}^2 + \varphi_{1374}^2 + \varphi_{1376}^2 + \varphi_{1378,bot}^2$$

$$OVL \quad = \frac{1}{2}[(\varphi_{bot}^1 - \varphi_{top}^1) + (\varphi_{bot}^2 - \varphi_{top}^2)]$$

1400

```
      ┌─────────────────────────┐
      │                         │
      │          1402           │
      │                         │
      └─────────────────────────┘
                   │
                   ▼
      ┌─────────────────────────┐
      │                         │
      │          1404           │
      │                         │
      └─────────────────────────┘
                   │
                   ▼
      ┌─────────────────────────┐
      │                         │
      │          1406           │
      │                         │
      └─────────────────────────┘
                   │
                   ▼
      ┌─────────────────────────┐
      │                         │
      │          1408           │
      │                         │
      └─────────────────────────┘
```

Fig. 14

Fig. 15

Europäisches
Patentamt
European
Patent Office
Office européen
des brevets

# EUROPEAN SEARCH REPORT

**Application Number**

EP 24 21 5456

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | "METROLOGY METHOD AND ASSOCIATED METROLOGY DEVICE", RESEARCH DISCLOSURE JOURNAL, QUESTEL , vol. 720, no. 97 21 March 2024 (2024-03-21), XP007152506, ISSN: 0374-4353 Retrieved from the Internet: URL:https://www.researchdisclosure.com/database/RD720097 [retrieved on 2024-03-21] | 1-15 | INV. G03F7/20 G01N21/956 |
| Y | * paragraph [0035] - paragraph [0056] * * figures 5-7 * | 7-9 | |
| X | "METROLOGY METHOD AND ASSOCIATED METROLOGY DEVICE", RESEARCH DISCLOSURE JOURNAL, QUESTEL , vol. 720, no. 7 28 February 2024 (2024-02-28), XP007152420, ISSN: 0374-4353 Retrieved from the Internet: URL:https://www.researchdisclosure.com/database/RD720007 [retrieved on 2024-02-28] | 1-6, 10-15 | |
| Y | * paragraph [0035] - paragraph [0053] * * figures 5-6 * | 7-9 | |
| A | WO 2021/151754 A1 (ASML NETHERLANDS BV [NL]) 5 August 2021 (2021-08-05) * paragraph [0036] - paragraph [0063] * * paragraph [0092] * * paragraph [00106] * * figures 5-6 * | 7,8 | |

**TECHNICAL FIELDS SEARCHED (IPC)**

G03F

The present search report has been drawn up for all claims

| Place of search | Date of completion of the search | Examiner |
|---|---|---|
| Munich | 29 April 2025 | Maslankiewicz, Pawel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P4C01)

## ANNEX TO THE EUROPEAN SEARCH REPORT
## ON EUROPEAN PATENT APPLICATION NO.

EP 24 21 5456

This annex lists the patent family members relating to the patent documents cited in the above-mentioned European search report.
The members are as contained in the European Patent Office EDP file on
The European Patent Office is in no way liable for these particulars which are merely given for the purpose of information.

29-04-2025

| Patent document cited in search report | Publication date | Patent family member(s) | | Publication date |
|---|---|---|---|---|
| WO 2021151754 A1 | 05-08-2021 | CN | 115004113 A | 02-09-2022 |
| | | JP | 7365510 B2 | 19-10-2023 |
| | | JP | 2023511729 A | 22-03-2023 |
| | | KR | 20220122743 A | 02-09-2022 |
| | | TW | 202135192 A | 16-09-2021 |
| | | US | 2023064193 A1 | 02-03-2023 |
| | | WO | 2021151754 A1 | 05-08-2021 |

EPO FORM P0459

For more details about this annex : see Official Journal of the European Patent Office, No. 12/82

**REFERENCES CITED IN THE DESCRIPTION**

**Patent documents cited in the description**

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1